(19) Europäisches Patentamt

European Patent Office

Office européen des brevets

(11) Veröffentlichungsnummer: **0 426 218 B1**

(12) **EUROPÄISCHE PATENTSCHRIFT**

(45) Veröffentlichungstag der Patentschrift: **27.07.94**

(21) Anmeldenummer: **90202664.0**

(22) Anmeldetag: **05.10.90**

(51) Int. Cl.⁵: **C23C  16/06**, C23C 16/50, C23C 16/22

(54) **Mehrschichtstruktur und Verfahren zur plasmaaktivierten reaktiven Abscheidung von Mehrkomponentenmaterial aus einer Gasphase.**

(30) Priorität: **11.10.89 DE 3933900**

(43) Veröffentlichungstag der Anmeldung:
**08.05.91 Patentblatt  91/19**

(45) Bekanntmachung des Hinweises auf die
Patenterteilung:
**27.07.94 Patentblatt  94/30**

(84) Benannte Vertragsstaaten:
**DE FR GB IT NL**

(56) Entgegenhaltungen:
EP-A- 0 170 359          EP-A- 0 207 767
EP-A- 0 289 173          EP-A- 0 324 523
FR-A- 2 314 263          GB-A- 2 166 162
US-A- 4 777 061

(73) Patentinhaber: **Philips Patentverwaltung GmbH**
**Wendenstrasse 35c**
**D-20097 Hamburg(DE)**

(84) Benannte Vertragsstaaten:
**DE**

(73) Patentinhaber: **N.V. Philips' Gloeilampenfabrieken**
**Groenewoudseweg 1**
**NL-5621 BA Eindhoven(NL)**

(84) Benannte Vertragsstaaten:
**FR GB IT NL**

(72) Erfinder: **Gärtner, Georg, Dr.**
**Reinhardstrasse 66A**
**W-5100 Aachen(DE)**

(74) Vertreter: **Koch, Ingo, Dr.-Ing. et al**
**Philips Patentverwaltung GmbH,**
**Wendenstrasse 35c**
**D-20097 Hamburg (DE)**

Rank Xerox (UK) Business Services
(3. 10/3.0 9/3.3.3)

## Beschreibung

Die Erfindung betrifft ein Verfahren zur PCVD-Abscheidung einer aus mindestens zwei verschiedenen Stoffen bestehenden Mehrkomponentenschicht auf einem Substrat, wobei aus unterschiedlichen Stoffen der Mehrkomponentenschicht bestehende Teilschichten mit einer Dicke von weniger als 100 nm gebildet werden, und wobei in einem Reaktionsraum ein Plasma erzeugt wird, welches dem Substrat gegenüber periodisch zwischen Umkehrpunkten bewegt wird.

Ein Verfahren ähnlicher Art ist aus EP-A-O 204 356 bekannt. Bei dem darin beschriebenen Verfahren wird zwischen einer Innenelektrode und einer Außenelektrode, von denen eeine rohrförmig ausgebildet ist und als Substrat für das abzuscheidende Material dient, eine lokal begrenzte Glimmentladungszone erzeugt, die während der Abscheidung beibehalten wird. Dabei erfolgt eine gesteuerte Hin- und Herbewegung einer der Elektroden relativ zur anderen Elektrodeund damit eine entsprechende Bewegung der Glimmentladungszone (dynamische PCVD) und es werden Maßnahmen getroffen, um die Bildung von elektrisch leitenden Schichten auf elektrisch isolierenden Konstruktionsteilen im Reaktionsraum zu verhindern. Die Temperatur im Substratbereich wird auf einem niedrigen Wert konstant gehalten, bei dem die thermische Abscheiderate klein ist gegenüber der Abscheiderate mit Glimmentladung.

Aus EP-A-O 252 548 ist es bekannt, Schichten aus elektrisch leitendem Werkstoff in einem stehenden Mikrowellenfeld abzuscheiden. Die Abscheidung erfolgt auf einem elektrisch leitenden Substrat, bei dem ein Teil der Oberfläche einen Teil der Innenwandung eines Mikrowellen-Hohlraumresonators bildet. Es werden Maßnahmen getroffen, um die Einkoppelstelle der Mikrowelle ("Fenster") von elektrisch leitendem Bewuchs freizuhalten. Vorzugsweise wird die Unterlage relativ zum Plasma und zur übrigen Wandung des Resonators periodisch oder aperiodisch verschoben, woraus sich eine entsprechende Plasmabewegung ergibt.

Ein PCVD-Verfahren, bei dem ein gepulstes Plasma und Druckpulse angewendet werden, ist aus EP-A-0 207 767 bekannt.

Als Ausgangsmaterialien für die einzelnen Komponenten des Mehrkomponentenmaterials enthält die strömende Gasphase bei dem Verfahren nach EP-A-0 204 356 vorzugsweise mindestens ein Halogenid oder Carbonyl von Wolfram, Molybdän, Tantal, Niob, Rhenium, Hafnium, Iridium, Osmium, Platin, Rhodium, Ruthenium und/oder Zirkonium und mindestens eine metallorganische Verbindung eines Elements der Gruppe III b des Periodensystems (Scandium-Gruppe) sowie zusätzlich ein Inertgas und gegebenenfalls Wasserstoff.

Die aus EP-A-0 204 356 bekannte Herstellung von Mehrkomponentenmaterial per PCVD aus einem Gasgemisch ist als Simultan-PCVD zu verstehen. Ein Umschalten auf eine andere Gaszusammensetzung erfolgt hier, um auf einer abgeschiedenen Schicht eine darüberliegende Schicht aus anderem Material abzuscheiden.

Mit dem bekannten Verfahren werden z.B. selbsttragende elektrisch leitende thorierte Wolframzylinder hergestellt. Die Konzentration von Thoriumoxid in Wolfram liegt dabei zwischen 0,5 und 10 Gew.%. Das Verfahren ist zur Dotierung von Wolfram oder anderen Refraktärmetallen sowohl mit Actiniden und deren Oxiden als auch mit Scandium, Yttrium und Seltenerdmetallen und deren Oxiden geeignet. Anstelle selbsttragender Zylinder können auch Überzüge auf vorhandenen Strukturen nach dem bekannten verfahren hergestellt werden.

Bei Untersuchungen, die zur Erfindung geführt haben, hat sich herausgestellt, daß sich bei dem bekannten verfahren metallorganische Ausgangsverbindungen zwar bei Molverhältnissen von W:Th (oder einem anderen Element aus der III b-Gruppe des Periodensystems) im Bereich von etwa 20:1 gut verwenden lassen, ohne daß zu viel unerwünschter Kohlenstoff oder unerwünschtes Fluor abgeschieden werden, daß dies aber nicht mehr gilt, wenn man das Molverhältnis um eine Größenordnung ändert und statt einer Dotierung eine Mischung herstellen will, z.B. der Komponenten W:Sc im Molverhältnis 2:1 oder 3:1.

Der Erfindung liegt die Aufgabe zugrunde, ein PCVD-Verfahren zur Herstellung einer Mehrkomponentenschicht aus mehreren Teilschichten zu schaffen, durch das Mehrkomponentenmaterial uniformer Zusammensetzung erhalten wird.

Diese Aufgabe wird erfindungsgemäß dadurch gelöst, daß die Teilschichten zeitlich nacheinander aus die unterschiedlichen Stoffe enthaltenden reaktiven Gasphasen abgeschieden werden, daß einer strömenden Gasphase Ausgangsmaterialien für die einzelnen Teilschichten des Mehrkomponentenmaterials in der Weise zugesetzt werden, daß die strömende Gasphase alternierend nur jeweils Ausgangsmaterial für eine einzelne Teilschicht des Mehrkomponentenmaterials enthält, und daß Einzelschichten mehrmals jeweils nach Bildung von mindestens einer aus anderen Stoffen bestehenden Einzelschicht aufgebracht werden.

Vorteilhafte Ausführungsformen der erfindungsgemäßen Mehrschichtstruktur bestehen darin, daß
- die Dicke einer Teilschicht 10 bis 60 nm ist,
- eine Teilschicht mit Komponenten A und eine weitere Teilschicht mit Komponenten B gebildet wird, wobei das Molverhältnis zwischen den Komponenten A und B kleiner als oder gleich 3 ist,

- die Komponenten A ein oder mehrere Elemente aus der Gruppe Wolfram, Molybdän, Tantal, Niob, Phenium, Hafnium, Iridium, Osmium, Platin, Rhodium, Ruthenium und Zirkonium umfassen und die Komponenten B ein oder mehrere Elemente aus der Gruppe III b des Periodensystems (Scandium-Gruppe) umfassen,
- die Mehrkomponentenschicht vorzugsweise Wolfram und Scandium enthält.

Ferner wird zur Lösung dieser Aufgabe erfindungsgemäß bei einem verfahren der eingangs genannten Art die strömende Gasphase in mindestens zwei strömende Gasphasen aufgeteilt, die jeweils nur Ausgangsmaterial für eine einzelne Teilschicht des Mehrkomponentenmaterials enthalten; die einzelnen Gasphasen werden dem Plasma wiederholt zeitlich aufeinanderfolgend zugeführt.

Das Plasma ist z.B. ein Glimmentladungsplasma, ein Hochfrequenzplasma oder ein Mikrowellenplasma.

Die einzelnen Gasphasen werden vorzugsweise einem lokalisierten Gleichstrom-Glimmentladungsplasma zugeführt, das zwischen zwei relativ zueinander bewegten Elektroden ausgebildet und periodisch zwischen zwei Umkehrpunkten hin-und herbewegt wird; das Plasma wird auch beim Umschalten der Gasphasen kontinuierlich aufrechterhalten. Die Anwendung eines gepulsten Plasmas ist demnach zu vermeiden.

Beim erfindungsgemäßen verfahren ist es von Vorteil, intermittierend Plasma-Zwischenbehandlungen ohne die Ausgangsmaterialien der Hauptkomponenten des Mehrkomponentenmaterials einzuschieben. Hauptkomponenten sind in der Regel die Elemente, die in ungebundener Form als Metalle vorliegen.

Das erfindungsgemäße Verfahren wird vorzugsweise in einem Reaktor durchgeführt, in dem der Druck während der gesamten Betriebsdauer konstant gehalten wird, wobei die Massenflüsse aller Gaskomponenten ebenfalls konstant eingestellt bleiben und die jeweils nicht benötigten Komponenten über eine Umwegleitung am Reaktor vorbei in eine Auffangstation zur Gasentsorgung geleitet werden. Die Anwendung von Druckpulsen ist demnach zu vermeiden.

Weitere vorteilhafte Ausführungsformen des erfindungsgemäßen Verfahrens bestehen darin, daß

- die strömenden Gasphasen zusätzlich auch in Subintervallen der Plasmabewegung zwischen den Umkehrpunkten jeweils hin- und hergeschaltet werden,
- in den Subintervallen der Plasmabewegung die Gasphase zwischen den einzelnen reaktiven Gemischen und zusätzlichen Plasma-Zwischenbehandlungen hin- und hergeschaltet wird,

- nach einer ganzen Zahl von Hüben der Plasmabewegung die in Subintervallen abgeschiedene axiale Schichtkomponentenbelegung der Belegung aus zwei alternierenden Hüben nach der grundlegenden Ausführungsform des erfindungsgemäßen Verfahrens entspricht,
- der Hub H der Plasmabewegung, der um ein Mehrfaches größer sein sollte als die Halbwertsbreite d des statischen PCVD-Abscheideprofils, in mehrere ($=m$) Teilhübe $H_i$ derart zerlegt wird, daß deren Anzahl m, die gleich der Anzahl der Subintervalle der Bewegung ist, größer als H/d ist,
- die strömenden Gasphasen als Ausgangsmaterialien einerseits Metallhalogenide von Wolfram, Molybdän, Ruthenium, Tantal und Niob und andererseits metallorganische Verbindungen der Scandium-Gruppe, der Seltenen Erden und/oder der Actiniden enthalten,
- zwischen den Gasphasen $WF_6/H_2/Ar$ und $Sc(C_5H_7O_2)_3/O_2/Ar$ und $Ar/O_2$ und $Ar$ hin- und hergeschaltet wird, wobei stets ein Plasma ausgebildet ist,
- das abgeschiedene Mehrkomponentenmaterial einer Wärmebehandlung unterzogen wird.

Da AES-Tiefenprofile des gemäß EP-A-0 204 356 hergestellten Mehrkomponentenmaterials wegen der unterschiedlichen statischen Konzentrationsprofile für die Einzelkomponenten stets eine relativ starke Konzentrationsmodulation der Einzelkomponenten (hier maßgeblich Scandium und Wolfram) zeigen, wird erfindungsgemäß statt der gemäß EP-A-0 204 356 angewendeten simultanen PCVD eine alternierende PCVD durchgeführt, z.B. von Scandium einerseits und Wolfram andererseits. Hierzu werden für die einzelnen Hübe, d.h. für jeweils eine Hin- oder Herbewegung, die reaktiven Gasgemische, z.B. $WF_6/H_2/Ar$ und $Sc(C_5H_7O_2)_3/O_2/Ar$, über Magnetventile oder elektropneumatische Ventile jeweils in einen Reaktor bzw. auf Umweg hin- und hergeschaltet, und es wird gegebenenfalls nach Abscheidung der scandiumhaltigen Schicht ($Sc_2O_3$-Schicht) eine $Ar/O_2$-Plasma-Zwischenbehandlung durchgeführt, wie sie in EP-A-0 324 523 beschrieben ist, und danach gegebenenfalls auch eine $Ar/H_2$-Plasma-Zwischenbehandlung und/oder nur eine Ar-Plasma-Zwischenbehandlung.

AES bedeutet Auger-Elektronen-Spektroskopie, d.h. eine Oberflächenuntersuchungsmethode zur Feststellung von Elementverteilungen bzw. der Oberflächenzusammensetzung bei Mehrstoffsystemen. Um eine Aussage über tieferliegende Schichten zu bekommen, müssen darüberliegende Schichten erst abgetragen werden, z.B. durch Absputtern mit Argon-Ionen. Führt man das nun kontinuierlich durch, so erhält man ein Tiefenprofil ( = Signal, nicht Konzentration) für die verschiedenen mitgescannten Elemente. Aus den bekannten Empfindlichkeiten können dann auch Aussagen über die Konzentrationsverteilungen gemacht werden.

Durch die erfindungsgemäße alternierende PCVD, gegebenenfalls mit intermittierender Plasma-Zwischenbehandlung, werden z.B. gut haftende W/(ScC + $Sc_2O_3$)-Vielschichtstrukturen erzielt, wobei durch Erhitzen auf Scandat-Kathoden-Betriebstemperaturen der noch verbliebene C-Anteil (etwa 1/2 C von ursprünglich 3 x 5 = 15 C aus Sc-$(C_5H_7O_2)_3$) verschwindet, die Einzelschichtstruktur durch Interdiffusion ausgeglichen wird und eine Mischung von Scandiumoxid und Wolfram in der gesamten Deckschicht erhalten wird. Zur Ermöglichung einer guten Interdiffusion ist es jedoch auch zweckmäßig, die Dicke der Einzelschichten durch mehrere Maßnahmen stark zu verringern:

(1) Die $WF_6(/H_2)$ und $Sc(C_5H_7O_2)_3$-Massenflüsse werden reduziert.

(2) Die Periodendauer wird durch apparative Maßnahmen verkürzt, z.B. von 1 min auf 40 s, d.h. 20 s pro Hub, oder kürzer.

(3) Die Geschwindigkeit der Plasmabewegung wird erhöht, z.B. von bisher maximal 19 cm/min auf 57 cm/min (bei jetzt verdoppeltem Hub von 19 cm), oder noch weiter erhöht.

Dadurch wird die Dicke der "Doppel"schicht pro Periode (Tiefen-Modulations"periode") von etwa 1 μm auf 60 nm reduziert.

"Tiefen-Modulations"periode"" bedeutet periodisch wiederkehrende räumliche Abfolge der Konzentrationsmodulation in Richtung des Schichtenwachstums.

Sämtliche zuvor angegebenen Änderungen sind im Vergleich mit den beispielsweisen Angaben in EP-A-0 204 356 zu betrachten.

Zur weiteren Verbesserung der Interdiffusion (besserer Konzentrationsausgleich), vor allem auch im oberflächennahen Bereich, ist es zweckmäßig, eine bereits zuvor erwähnte wichtige erfindungsgemäße Verfahrensänderung vorzunehmen:
Da die Geschwindigkeit der Plasmabewegung apparativ begrenzt ist, werden zusätzlich die strömenden Gasphasen (Gasflässe) auch in Subintervallen zwischen den Umkehrpunkten jeweils hin- und hergeschaltet. Ein solches Vorgehen zeigt zwar bei einem sehr schmalen statischen Profil und vergleichsweise großem Hub keine Wirkung auf ein höherfrequentes moduliertes Tiefenprofil, bei einer größeren Ausdehnung des statischen Profils (z.B. 7 cm bei 19 cm Hub) wird jedoch eine zusätzliche subperiodische Modulation des Tiefenprofils erzielt. Dazu wird mit Hilfe einer Prozeßrechnersteuerung die Zeit zwischen den Umkehrpunkten, an denen Interruptsignale auftreten, in m gleiche Intervalle, also in Subintervalle, geteilt, und es werden die Gasflüsse am Ende bzw. Beginn eines jeden Intervalls umgeschaltet. Die Subintervalldauern müssen dabei länger als die Gasaustauschzeiten im Reaktionsraum sein, was z.B. bei Subintervalldauern von 3 s oder mehr stets gut erfüllt wird.

Einige Ausführungsbeispiele der Erfindung sind in einer Zeichnung dargestellt und werden im folgenden näher beschrieben.

Die Zeichnung zeigt fünf Diagramme (Fig. 1 bis 5), in denen bei dem Verfahren und mit der Vorrichtung nach EP-A-0 204 356, wobei die Innenelektrode in Rohrrichtung periodisch gesteuert längs der Außenelektrode hin- und herbewegt wird und wobei die Innenelektrode als Anode und die Außenelektrode als Kathode gepolt wird, angewandte zeitliche Abfolgepläne für die Gasflüsse in den Subintervallen dargestellt sind, wobei die Bedingung erfüllt wird, daß in jeder Periode bzw. in zwei oder vier aufeinanderfolgenden Bewegungsperioden dieselbe Gesamtkonzentration der Einzelkomponenten wie bei der Hub-alternierenden PCVD erhalten wird. Es zeigen

Fig. 1: einen Abfolgeplan ohne Plasma-Zwischenbehandlung; eine Periode (hier dargestellt für m gerade, m = 6),

Fig. 2: einen Abfolgeplan mit $Ar/O_2$-Plasma-Zwischenbehandlung während ganzer Hübe; eine Beschichtungsperiode, zwei Bewegungsperioden,

Fig. 3: Abfolgepläne mit alternierender PCVD und

u.Fig.4: $Ar/O_2$- bzw. Ar,-Plasma-Zwischenbehandlung (hier m = 4 bzw. 5) zwei Bewegungsperioden, Start am unteren bzw. oberen Umkehrpunkt) und

Fig.5: einen Abfolgeplan, bei dem m ungerade ist (hier m = 1, Subintervall = Hub).

In den Figuren bedeuten

| | |
|---|---|
| H | Hub |
| $H_{auf}$ | Aufwärtshub |
| $H_{ab}$ | Abwärtshub |
| $U_o$ | oberer Umkehrpunkt |
| $U_u$ | unterer Umkehrpunkt |
| A | Anodenbewegung ( = Plasmabewegung) |
| S | Subintervall |
| 1,2,3,4,5,6 | Nummerierung der Subintervalle. |

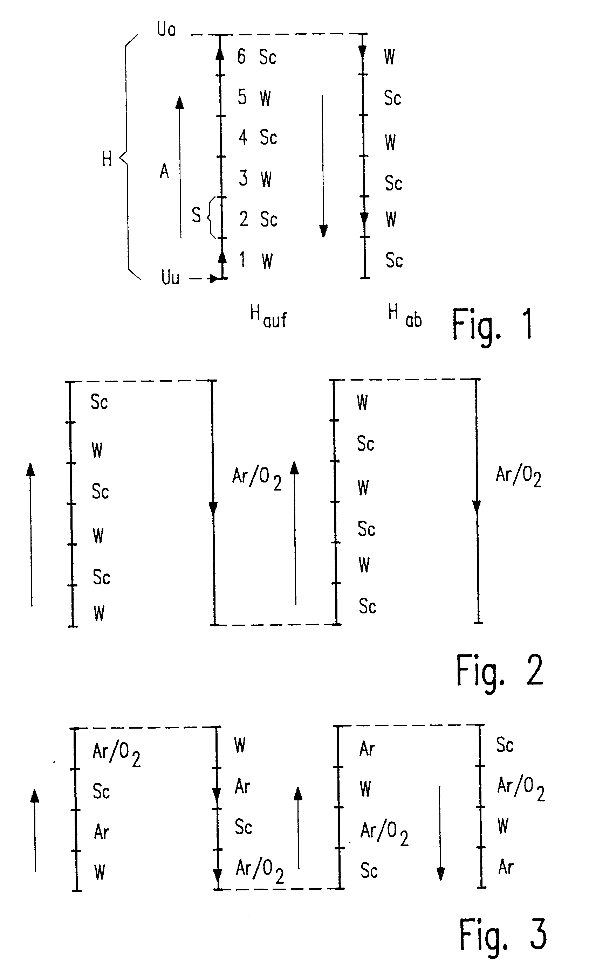

Diese Bezeichnungen sind nur in Fig.1 zu finden, sie wurden in den Fig. 2 bis 5 der Einfachheit halber weggelassen. Weiter bedeuten in den Figuren

| | |
|---|---|
| W | W-PCVD, z.B. mit dem reaktiven Gasgemisch $WF_6/H_2/Ar$ |
| Sc | Sc-PCVD, z.B. mit dem reaktiven Gasgemisch, $Sc(C_5H_7O_2)_3/O_2/Ar$, wobei Sc für die bestimmende Komponente steht, |

auch wenn tatsächlich $Sc_2O_3$ ($+$ ScC) abgeschieden wird

Ar/$O_2$  Ar/$O_2$-Plasma-Zwischenbehandlung

Ar  Ar-Plasma-Zwischenbehandlung

Eine Periode der Anodenbewegung A ist gleich dem Zeitintervall $t_{Per}$ ($t_{Per}$ = $t_{Hauf}$ + $t_{Hab}$) bei (gleichförmiger) linearer Auf- und Abbewegung zwischen dem unteren Umkehrpunkt $U_u$ über den oberen Umkehrpunkt $U_o$ wieder zurück zum unteren Umkehrpunkt.

Gemäß Fig. 1 wird eine alternierende PCVD ohne Ar(/$O_2$)-Plasma-Zwischenbehandlung durchgeführt. Oberer und unterer Umkehrpunkt der Anodenbewegung und die anzuwendende Geschwindigkeit sind eingestellt. Bei Start der Anode am Umkehrpunkt unten wird das reaktive Gasgemisch für W-PCVD (= $WF_6$/$H_2$/Ar) auf Durchfluß durch den Reaktionsraum geschaltet, bis nach $t_H$/m auf das reaktive Gasgemisch für Sc-PCVD, was wie gesagt bedeutet, für scandiumhaltige Abscheidung, zum Durchfluß durch den Reaktionsraum umgeschaltet wird, wobei die nicht benötigten Gase jeweils immer auf Umweg am Reaktionsraum vorbei geschaltet werden. In den folgenden Subintervallen der Dauer $t_H$/m wird nun wieder abwechselnd, auf W-PCVD, dann auf Sc-PCVD und so weiter umgeschaltet, bis nach $m(t_H$/m) + $m(t_H$/m) Intervallen eine Periode der Anodenbewegung ausgeführt ist. Eine solche Periode kann mehrfach wiederholt werden.

Gemäß Fig. 2 wird im Unterschied zu Fig. 1 nach einem Hub der Dauer $m(t_H$/m) im folgenden Hub auf Ar/$O_2$-Plasma umgeschaltet und es werden für die Dauer $t_H$ keine Subintervallumschaltungen der Gasphase vorgenommen bis zum gegenüberliegenden Umkehrpunkt. Dort wird auf das Gemisch für scandiumhaltige Abscheidung umgeschaltet, bis nach $t_H$/m dann wiederum W-PCVD durchgeführt wird. Danach erfolgt während der sukzessiven Subintervalle der Dauer $t_H$/m wieder abwechselnd Sc-PCVD und W-PCVD bis zum oberen Umkehrpunkt. Von dort bis unten erfolgt wieder für das gesamte $t_H$ eine Plasma-Zwischenbehandlung.

Bei dem Abfolgeplan gemäß Fig.3 brennt die Glimmentladung während des ganzen Vorganges ununterbrochen im Reaktionsraum, während sich die Anode mit gleichförmiger Geschwindigkeit zwischen den Umkehrpunkten hin- und herbewegt. Das Gasgemisch wird jeweils nach $t_H$ umgeschaltet, und zwar wird nach dem Start unten jeweils von $WF_6$/$H_2$/Ar auf Ar auf Sc-Verbindung/$O_2$/Ar auf Ar/$O_2$ umgeschaltet. Nach dem Umkehrpunkt oben wird wieder für $t_H$/m auf $WF_6$/$H_2$/Ar, danach für das folgende Subintervall auf Ar und danach auf Sc-Verbindung/$O_2$/Ar und schließlich auf Ar/$O_2$ bis zum Umkehrpunkt unten umgeschaltet. Damit ist zwar noch nicht jedes, jetzt auch örtlich zu sehende, Subintervall mit jeweils einer W- und einer Sc-Oxid-Beschichtung versehen, was jedoch in den zwei folgenden Hüben in der Subintervallabfolge Sc-PCVD - Ar/$O_2$ -W-PCVD - Ar (aufwärts) und Sc-PCVD - Ar/$O_2$ - W-PCVD - Ar (abwärts) erfolgt. Eine solche eben beschriebene Beschichtungsabfolge kann nun mehrfach wiederholt werden.

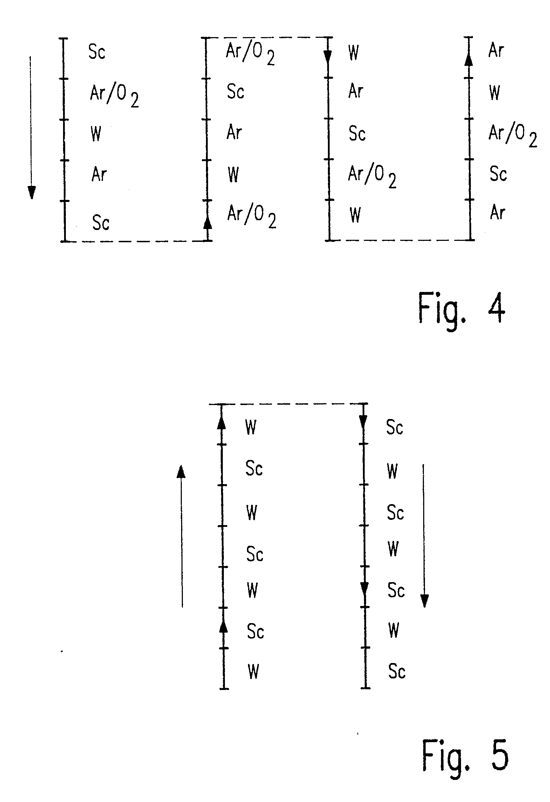

Gemäß Fig. 4 erfolgt der Start am oberen Umkehrpunkt. Im übrigen ähnelt der Abfolgeplan gemäß Fig.4 dem Abfolgeplan gemäß Fig. 3. Mit genau der einmaligen Abfolge der Fig. 4 wurden bei Beschichtung von mit 4 $BaO.CaO.Al_2O_3$ imprägnierten Kathodenpillen Deckschicht-Scandatkathoden mit hoher Elektronen-Emissionsstromdichte bei 950 ° C Kathodentemperatur erhalten.

Gemäß Fig. 5 ist der zeitliche Abfolgeplan so zu konstruieren, daß zu jeder Subintervallbeschichtung im selben axialen Intervall auch später die dazu komplementäre Beschichtung (bei zwei Komponenten) vorgenommen wird. Es wurde eine Beschichtung mit sieben Subintervallen vorgenommen (Zwischenbehandlung z.B. nach jedem Hub möglich, aber nicht durchgeführt). Dabei tritt während des Aufwärtshubs ein geringfügiger W-Überschuß ($t_W$:$t_{Sc}$~ 4:3) und während des Aufwärtshubs ein Sc-Überschuß auf.

Wegen Substratunebenheiten, die die "Tiefenauflösung" (siehe unten) beim Sputtern herabsetzen, konnte bei AES-Tiefenprofilen keine Substruktur mehr aufgelöst werden, jedoch war der Modulationshub der Einzelkonzentrationen deutlich verringert und entsprach in etwa dem geringen W- bzw. Sc-Überschuß pro Hub. Natürlich ist eine nach Maßgabe des statischen Abscheideprofils unregelmäßige Substruktur der Konzentration in der Tiefe an einem axialen Ort z zu erwarten, die sich jedoch bei vielen Bewegungsperioden periodisch wiederholt. Sehr sinnvoll und wirkungsvoll wird das erfindungsgemäße Verfahren dann, wenn der Abstand zwischen zwei benachbarten Subintervall-Umschaltpunkten (Subintervall-Hub) kleiner als die oder gleich der Breite des statischen Profils ist. Außerdem kann dieses Verfahren für eine zusätzliche Homogenisierung benutzt werden, wenn bei zwei Komponenten die statischen Maxima gegeneinander verschoben sind. Die Abfolge ist dann so zu wählen, daß die in Strömungsrichtung später abgeschiedene Komponente im Subintervall vor der statisch zuerst abgeschiedenen Komponente aufgebracht wird. Der geometrische Subintervall-Hub ist dann durch Anodengeschwindigkeit und Subintervall zweckmäßigerweise so festzulegen, daß er in etwa dem Abstand der beiden Konzentrationsmaxima entspricht. Das Subintervallverfahren ermöglicht es also, trotz alternierender PCVD eine noch weitergehende Durchmischung zu erzielen, wobei die Tiefenmodulation der Konzentrationen durch Interdiffusion noch besser und schneller ausgeglichen werden kann. Die charakteristischen Schichtdicken für die so erzielte Sub-Modulation liegen bereits im Bereich von 10 nm.

"Tiefenauflösung" bedeutet Auflösung, d.h. räumliche Genauigkeit bei Messung der Änderung der Konzentration, in Wachstumsrichtung der Schicht/en ( = in der Tiefe, von der Oberfläche aus gesehen).

Die Stoffklassen für die Ausgangsmaterialien sind ganz allgemein:

(a) Metallhalogenide, z.B. von Wolfram, Molybdän, Rhenium, Tantal und Niob, und

(b) metallorganische Verbindungen, z.B. der Scandium-Gruppe, der Seltenen Erden und/oder der Actiniden,

zur Herstellung von Phasenzusammensetzungen Metall-(Metall)oxid. Das Verfahren ist jedoch viel allgemeiner für Zweistoffsysteme und Mehrstoffsysteme zu sehen und es kann z.B. auch statt einer Oxid-Bildung eine Nitrid- oder Carbid-Bildung die Zielsetzung sein. Insofern können auch alle flüchtigen, für CVD einsetzbaren Verbindungen verwendet werden, wobei die jeweilige Subintervall-Phasenzusammensetzung durch reaktive Gaskomponenten wie z.B. Sauerstoff, Wasserstoff und Stickstoff, Kohlenwasserstoffe oder geeignete Sauerstoff-, Stickstoff- und Kohlenstoff-Verbindungen eingestellt wird.

Statt einer gleichförmigen Anodenbewegung kann auch eine geeignete ungleichförmige Anodenbewegung bzw. Plasmabewegung, z.B. mit Geschwindigkeitsrampen vor den Umkehrpunkten, durchgeführt werden.

**Patentansprüche**

1. Verfahren zur PCVD-Abscheidung einer aus mindestens zwei verschiedenen Stoffen bestehenden Mehrkomponentenschicht auf einem Substrat, wobei aus unterschiedlichen Stoffen der Mehrkomponentenschicht bestehende Teilschichten mit einer Dicke von weniger als 100 nm gebildet werden, und wobei in einem Reaktionsraum ein Plasma erzeugt wird, welches dem Substrat gegenüber periodisch zwischen Umkehrpunkten bewegt wird, dadurch gekennzeichnet, daß die Teilschichten zeitlich nacheinander aus die unterschiedlichen Stoffe enthaltenden reaktiven Gasphasen abgeschieden werden, daß einer strömenden Gasphase Ausgangsmaterialien für die einzelnen Teilschichten des Mehrkomponentenmaterials in der Weise zugesetzt werden, daß die strömende Gasphase alternierend nur jeweils Ausgangsmaterial für eine einzelne Teilschicht des Mehrkomponentenmaterials enthält, und daß Einzelschichten mehrmals jeweils nach Bildung von mindestens einer aus anderen Stoffen bestehenden Einzelschicht aufgebracht werden.

2. Verfahren nach Anspruch 1, dadurch gekennzeichnet, daß die Teilschichten durch Erhitzung vermischt werden.

3. Verfahren nach Anspruch 1 oder 2, dadurch gekennzeichnet, daß die Teilschichten mit einer Dicke von 10 bis 60 nm abgeschieden werden.

4. Verfahren nach einem der Ansprüche 1 bis 3, dadurch gekennzeichnet, daß eine Teilschicht mit Komponenten A und eine weitere Teilschicht mit Komponenten B gebildet wird, wobei das Molverhältnis zwischen den Komponenten A und B kleiner als oder gleich 3 ist.

5. Verfahren nach Anspruch 4, dadurch gekennzeichnet, daß die Komponenten A ein oder mehrere Elemente aus der Gruppe Wolfram, Molybdän, Tantal, Niob, Rhenium, Hafnium, Iridium, Osmium, Platin, Rhodium, Ruthenium und Zirkonium umfassen und die Komponenten B ein oder mehrere Elemente aus der Gruppe III b des Periodensystems (Scandium-Gruppe) umfassen.

6. Verfahren nach Anspruch 5, dadurch gekennzeichnet, daß die Mehrkomponentenschicht Wolfram und Scandium enthält.

7. Verfahren nach einem der Ansprüche 1 bis 6, dadurch gekennzeichnet, daß die einzelnen Gasphasen einem lokalisierten Gleichstrom-Glimmentladungsplasma zugeführt werden, das zwischen zwei relativ zueinander bewegten Elektroden ausgebildet und periodisch zwischen zwei Umkehrpunkten hin- und herbewegt wird, und das Plasma auch beim Umschalten der Gasphasen kontinuierlich aufrechterhalten wird.

8. Verfahren nach einem der Ansprüche 1 bis 7 dadurch gekennzeichnet, daß intermittierend Plasma-Zwischenbehandlungen ohne die Ausgangsmaterialien der Hauptkomponenten des Mehrkomponentenmaterials eingeschoben werden.

9. Verfahren nach einem der Ansprüche 1 bis 8, dadurch gekennzeichnet, daß es in einem Reaktor durchgeführt wird, in dem der Druck während der gesamten Betriebsdauer konstant gehalten wird, wobei die Massenflüsse aller Gaskomponenten ebenfalls konstant eingestellt bleiben und die jeweils nicht benötigten Komponenten über eine Umwegleitung am Reaktor vorbei in eine Auffangstation zur Gasentsorgung geleitet werden.

**10.** Verfahren nach einem der Ansprüche 1 bis 9, <u>dadurch gekennzeichnet</u>, daß die strömenden Gasphasen zusätzlich auch in Subintervallen der Plasmabewegung zwischen den Umkehrpunkten jeweils hin- und hergeschaltet werden.

**11.** Verfahren nach Anspruch 10, <u>dadurch gekennzeichnet</u>, daß in den Subintervallen der Plasmabewegung die Gasphase zwischen den einzelnen reaktiven Gemischen und zusätzlichen Plasma-Zwischenbehandlungen hin- und hergeschaltet wird.

**12.** Verfahren nach Anspruch 10 und/oder 11, <u>dadurch gekennzeichnet</u>, daß der Hub H der Plasmabewegung, der um ein Mehrfaches größer sein sollte als die Halbwertsbreite d des statischen PCVD-Abscheideprofils, in mehrere (=m) Teilhübe derart zerlegt wird, daß deren Anzahl m, die gleich der Anzahl der Subintervalle der Bewegung ist, größer als H/d ist.

**13.** Verfahren nach einem der Ansprüche 1 bis 12, <u>dadurch gekennzeichnet</u>, daß die strömenden Gasphasen als Ausgangsmaterialien einerseits Metallhalogenide von W, Mo, Re, Ta, Nb und andererseits metallorganische Verbindungen der Sc-Gruppe, der Seltenen Erden und/oder der Actiniden enthalten.

**14.** Verfahren nach Anspruch 13, <u>dadurch gekennzeichnet</u>, daß zwischen den Gasphasen $WF_6/H_2/Ar$ und $Sc(C_2H_7O_2)_3, O_2/Ar$ und $Ar/O_2$ und Ar hin- und hergeschaltet wird, wobei stets ein Plasma ausgebildet ist.

## Claims

**1.** A method of PCVD deposition of a multicomponent layer comprising at least two different materials on a substrate, in which sub-layers consisting of different materials of the multicomponent layer are formed with a thickness of less than 100 nm, and in which a plasma is generated in a reaction space and moved periodically with respect to the substrate between points of reversal, characterised in that the sub-layers are time-sequentially deposited from the reactive gas phases comprising different materials, in that starting materials for the individual sub-layers of the multicomponent material are added to a flowing gas phase in such a way that the flowing gas phase alternately comprises only starting material for a single sub-layer of the multicomponent material, and in that single layers are repeatedly provided each time after at least one single layer consisting of other materials has been formed.

**2.** A method as claimed in Claim 1, characterized in that the sub-layers are mixed by heating.

**3.** A method as claimed in Claims 1 or 2, characterized in that the sub-layers are deposited with a thickness of 10 to 60 nm.

**4.** A method as claimed in any one of Claims 1 to 3, characterized in that a sub-layer is formed with components A and a further sub-layer is formed with components B, the molar ratio between the components A and B being less than or equal to 3.

**5.** A method as claimed in Claim 4, characterized in that the components A comprise one or more of the elements from the group of tungsten, molybdenum, tantalum, niobium, rhenium, hafnium, iridium, osmium, platinum, rhodium, ruthenium and zirconium and the components B comprise one or more of the elements of the group III b of the periodic system (scandium group).

**6.** A method as claimed in Claim 5, characterized in that the multicomponent layer comprises tungsten and scandium.

**7.** A method as claimed in any one of Claims 1 to 6, characterized in that the single gas phases are applied to a localized d.c. glow discharge plasma which is formed between two electrodes which are movable relative to each other and is periodically reciprocated between two points of reversal and in that the plasma is continuously maintained also when switching the gas phases.

**8.** A method as claimed in any one of Claims 1 to 7, characterized in that intermediate plasma treatments without using the starting materials of the main components of the multicomponent material are performed intermittently.

**9.** A method as claimed in any one of Claims 1 to 8, characterized in that it is carried out in a reactor in which the pressure is maintained constant throughout the operating period , while the mass flows of all gas components also remain constantly adjusted and the components which are not required are conducted to a gas disposal station <u>via</u> a lead bypassing the reactor.

**10.** A method as claimed in any one of Claims 1 to 9, characterized in that the flowing gas phases are also reciprocated between the points of reversal during subintervals of the plasma movement.

**11.** A method as claimed in Claim 10, characterized in that in the subintervals of the plasma movement the gas phase is reciprocated between the single reactive mixtures and the additional intermediate plasma treatments.

**12.** A method as claimed in Claim 10 and/or 11, characterized in that the stroke H of the plasma movement which should be larger by a multiple than the half-value width $\underline{d}$ of the static PCVD deposition profile is divided into a plurality ($=\underline{m}$) of partial strokes Hi in such a way that its number $\underline{m}$, which is equal to the number of subintervals of the movement, is larger than H/d.

**13.** A method as claimed in any one of Claims 1 to 12, characterized in that the flowing gas phases comprise as starting materials metal halide of W, Mo, Re, Ta, Nb on the one hand and metalorganic compounds of the Sc group, the rare earths and/or the actinides on the other hand.

**14.** A method as claimed in Claim 13, characterized in that there is reciprocation between the gas phases $WF_6/H_2/Ar$ and $Sc(C_5H_7O_2)_3/O_2/Ar$ and $Ar/O_2$ and Ar, with a plasma being formed each time.

**Revendications**

**1.** Procédé de dépôt PCVD, sur un substrat, d'une couche à plusieurs constituants consistant en au moins deux matières différentes, suivant lequel des couches partielles consistant en les différentes matières de la couche à plusieurs constituants, sont formées en une épaisseur de moins de 100 nm, et suivant lequel dans l'espace de réaction est créé un plasma qui est déplacé périodiquement entre des points de rebroussement par rapport au substrat, caractérisé en ce que les couches partielles sont déposées en succession dans le temps à partir des phases gazeuses réactives contenant des matières différentes, que des matières de départ pour les couches partielles particulières de la matière à plusieurs composants sont ajoutées à une phase gazeuse en écoulement de façon que la phase gazeuse en écoulement ne contienne en alternance, chaque fois que la matière de départ pour une couche partielle individuelle de la matière à plusieurs composants et que des couches individuelles sont déposées à plusieurs reprises, chacune après la formation d'au moins une couche individuelle faite d'une autre matière.

**2.** Procédé suivant la revendication 1, caractérisé en ce que les couches partielles sont mélangées par chauffage.

**3.** Procédé suivant la revendication 1 ou 2, caractérisé en ce que les couches partielles sont déposées en une épaisseur de 10 à 60 nm.

**4.** Procédé suivant l'une quelconque des revendications 1 à 3, caractérisé en ce qu'une couche partielle comprenant les composants A et une autre couche partielle supplémentaire comprenant les composants B sont formées, le rapport molaire entre les composants A et B étant inférieur ou égal à 3.

**5.** Procédé suivant la revendication 4, caractérisé en ce que les composants A contiennent un ou plusieurs éléments de la classe formée par le tungstène, le molybdène, le tantale, le niobium, le rhénium, le hafnium, l'iridium, l'osmium, le platine, le rhodium, le ruthénium et le zirconium et les composants B contiennent un ou plusieurs éléments du groupe IIIb du système périodique (groupe du scandium).

**6.** Procédé suivant la revendication 5, caractérisé en ce que la couche à plusieurs composants contient du tungstène et du scandium.

**7.** Procédé suivant l'une quelconque des revendications 1 à 6, caractérisé en ce que les phases gazeuses individuelles sont amenées à un plasma de décharge luminescente en courant continu localisé qui est entretenu entre deux électrodes mues l'une par rapport à l'autre et qui est déplacé en va-et-vient périodiquement entre deux points de rebroussement et le plasma est entretenu de façon continue même lors de la permutation des phases gazeuses.

**8.** Procédé suivant l'une quelconque des revendications 1 à 7, caractérisé en ce que des traitements intermédiaires par le plasma en l'absence des matières de départ des composants principaux de la matière à plusieurs composants sont insérés.

**9.** Procédé suivant l'une quelconque des revendications 1 à 8, caractérisé en ce qu'il est exécuté dans un réacteur dans lequel la pression est maintenue constante pendant toute la durée de l'opération, le flux massique de tous les composants gazeux étant également maintenu constant et les composants non nécessaires étant amenés chacun par une conduite de dérivation au-delà du réacteur dans un poste de captage pour l'épuration du gaz.

10. Procédé suivant l'une quelconque des revendications 1 à 9, caractérisé en ce que les phases gazeuses en écoulement sont, en outre, lancées et retenues chacune même dans les sous-intervalles du mouvement du plasma entre les points de rebroussement.

11. Procédé suivant la revendication 10, caractérisé en ce que, dans les sous-intervalles du mouvement du plasma, la phase gazeuse est lancée et retenue entre les mélanges réactifs individuels et les traitements intermédiaires supplémentaires par le plasma.

12. Procédé suivant la revendication 10 et/ou 11, caractérisé en ce que la passe H du mouvement du plasma qui doit valoir plusieurs fois la demi-largeur d du profil de dépôt PCVD statique est divisée en plusieurs ( = m) passes partielles $H_i$ de façon que leur nombre m qui est égal au nombre des sous-intervalles du mouvement soit supérieur à H/d.

13. Procédé suivant l'une quelconque des revendications 1 à 12, caractérisé en ce que les phases gazeuses en écoulement contiennent comme matière de départ, d'une part, des halogénures métalliques de tungstène, de molybdène, de ruthénium, de tantale et de niobium et, d'autre part, des composés organométalliques du groupe du scandium, des terres rares et/ou des actinides.

14. Procédé suivant la revendication 13, caractérisé en ce que entre les phases gazeuses $WF_6/H_2/Ar$ et $Sc(C_5H_7O_2)_3$, $O_2/Ar$ et $Ar/O_2$ et Ar sont lancées et retenues cependant qu'un plasma est toujours entretenu.

Fig. 1

Fig. 2

Fig. 3

Sc
Ar/O$_2$
W
Ar
Sc

Ar/O$_2$
Sc
Ar
W
Ar/O$_2$

W
Ar
Sc
Ar/O$_2$
W

Ar
W
Ar/O$_2$
Sc
Ar

Fig. 4

W
Sc
W
Sc
W
Sc
W

Sc
W
Sc
W
Sc
W
Sc

Fig. 5